# EUROPEAN PATENT SPECIFICATION

(11) **EP 3 051 929 B1**
(45) Date of publication and mention of the grant of the patent: **04.12.2019**
(21) Application number: 15152801.5
(22) Date of filing: 28.01.2015
(51) Int. Cl.: H05K 7/14

(54) **Cable management assembly**
Kabelverwaltungsanordnung
Ensemble de gestion de câble

(43) Date of publication of application: 03.08.2016
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Huang, Chien-Li, Kaohsiung City (TW); Wang, Chun-Chiang, Kaohsiung City (TW)
(74) Representative: Viering, Jentschura & Partner mbB Patent- und Rechtsanwälte

(56) References cited:
- US-A1- 2010 193 646
- US-A1- 2014 158 646
- US-A1- 2014 158 834
- US-A1- 2014 183 306

## Description

### Field of the Invention

The present invention relates to a cable management assembly and, more particularly, to a cable management assembly having a cantilever-type supporting structure.

### Background of the Invention

The development of cable management assemblies is briefly stated as follows. Dubon et al. (US 7,472,795 B2) and Chen et al. (US 7,554,819 B2) invented cable management assemblies which include a supporting member and a cable management arm. The two ends of the supporting member are mounted to a pair of spaced-apart slide rail assemblies respectively in order for the supporting member to support the cable management arm.

Later on, Chen et al. (US 7,712,615 B2; US 8,231,014 B2; and US 8,251,321 B2) invented cable management assemblies which include a retractable supporting member. Basically, both ends of the supporting member are still required to be mounted to a pair of spaced-apart slide rail assemblies respectively in order for the supporting member to support the cable management arm.

In the recently invented cable management assemblies of Chen et al. (US 2014/0158646 A1, US 2014/0158834 A1, and US 2014/0183306 A1), only one end of the retractable supporting member is required to be mounted to one of a pair of slide rail assemblies in order to form a cantilever support for the cable management arm.

A cantilever-type retractable supporting member is capable of supporting a cable management arm extended to a great length. If the cable management arm can only be extended by a small distance, it will be inappropriate to use such a retractable supporting member.

US 2010/193646 A1 discloses a cable management assembly comprises a first arm, a second arm, a frame, a supporting seat, a first support member, a second support member and a slide. The frame is pivotally connected between the first and second arm. The first support member is pivotally connected to the support seat and the second support member is slidably connected to the first support member. The slide is pivotally connected to the frame and slidably connected to the second support member. When the second arm is pulled relatively to the first arm, the frame moves the support members.

US 2014/0183306 A1, discloses a cable management assembly according to the preamble of claim 1. The cable management assembly comprises a first arm, a second arm, a frame, a supporting seat, a first supporting member, a second supporting member, a slide and a stop member. The first support member is pivotally connected to the support seat and the second support member is slidably connected to the first support member. The slide is pivotally connected to the frame and slidably connected to the second support member. The frame therefore drives the supporting member.

### Summary of the Invention

The present invention relates to a cable management assembly according to claim 1. Advantageous embodiments are defined in the dependent claims. In the cable management assembly a supporting member is pivotally connected to a supporting base so that, when displaced, a cable management bracket of the cable management assembly can drive the supporting member to rotate relative to the supporting base.

The cable management assembly is for mounting to a pair of slide rail assemblies including a first slide rail assembly and a second slide rail assembly and carrying an object. The cable management assembly comprises a first cable management bracket adapted to be connected to the first slide rail assembly; a second cable management bracket pivotally connected to the first cable management bracket and adapted to be connected to the first slide rail assembly; a plurality of cable supporting features connected to the first cable management bracket and the second cable management bracket; a supporting base adapted to be connected to the second slide rail assembly; a supporting member configured for supporting at least one of the first cable management bracket and the second cable management bracket; and wherein the supporting member has a first end and a second end corresponding opposite in position to the first end, wherein the first end of the supporting member is pivotally connected to the supporting base via a pivotal connecting element, such that the supporting member is rotatable relative to the supporting base. The supporting member comprises an upright standing actuator mounted to the supporting member at a position adjacent to the second end and which actuator is located between the first cable management bracket and the second cable management bracket. Upon relative displacement of the first cable management bracket and the second cable management bracket, one of the first cable management bracket and the second cable management bracket drives the supporting member to rotate relative to the supporting base. The actuator is driven by the first cable management bracket to rotate the supporting member, such that the supporting member is rotated from an initial position when the first cable management bracket and the second cable management bracket are displaced from a retracted position toward an extended position. The actuator is driven by the second cable management bracket to rotate the supporting member, such that the supporting member is displaced toward the initial position when the first and the second cable management bracket are brought closer to each other.

Preferably, the first cable management bracket includes a cable management arm having a first end and a second end, the second cable management bracket includes a cable management arm having a first end and a second end, and the cable management assembly further includes an intermediate bracket pivotally connected between the first end of the cable management arm of the first cable management bracket and the first end of the cable management arm of the second cable management bracket.

Preferably, the cable management assembly further includes a first mounting bracket which is pivotally connected to the second end of the cable management arm of the first cable management bracket and via which the first cable management bracket can be connected to the first rail of the first slide rail assembly.

Preferably, the cable management assembly further includes a second mounting bracket which is pivotally connected to the second end of the cable management arm of the second cable management bracket and via which the second cable management bracket can be connected to the second rail of the first slide rail assembly.

Preferably, the supporting base has a sidewall and a base portion generally perpendicularly connected to the sidewall. The sidewall is provided with a mounting bracket via which the supporting base can be connected to the second slide rail assembly. Preferably, the base portion of the supporting base has a blocking member for limiting the angle by which the supporting member can be rotated relative to the base portion of the supporting base. Preferably, the supporting member has a main body connected between the first end and the second end. The actuator is mounted to the second end of the supporting member via an engaging member and is thereby rendered upright with respect to the main body of the supporting member.

Preferably, the cable management assembly further includes an elastic member for providing an elastic force when the supporting member is rotated relative to the supporting base. The supporting member can respond to the elastic force such that rotation of the supporting member relative to the supporting base is made easy.

Preferably, the supporting base includes an adjusting member movably connected to the supporting base; the adjusting member includes a first bracket, a second bracket, and a positioning element elastically mounted to one of the first bracket and the second bracket; and the supporting base further has a first positioning hole and a second positioning hole, both corresponding to the positioning element.

Preferably, and as an alternative, the supporting base includes an adjusting member movably connected to the supporting base; the adjusting member includes a first bracket, a second bracket, and a threaded hole provided between the first bracket and the second bracket; and the supporting base further has a slot. A portion of the slot corresponds in position to the threaded hole so that a threaded element can pass through the slot, connect with the threaded hole, and thus be fixed in position.

One of the advantageous features of implementing the present invention is that the supporting member of the cable management assembly is pivotally connected to the supporting base and therefore can be driven to rotate relative to the supporting base by one of the cable management brackets of the cable management assembly when this cable management bracket is displaced.

### Brief Description of the Drawings

The invention as well as a preferred mode of use and the advantages thereof will be best understood by referring to the following detailed description of some illustrative embodiments in conjunction with the accompanying drawings, in which:
FIG. 1 is a schematic drawing in which the cable management assembly in an embodiment of the present invention is mounted to a pair of slide rail assemblies carrying an object;
FIG. 2 is a schematic exploded view of the cable management assembly and the slide rail assemblies in FIG. 1;
FIG. 3 is a schematic exploded view of the cable management assembly in FIG. 1;
FIG. 4A is a schematic exploded view of the supporting member and the supporting base in FIG. 1;
FIG. 4B is a schematic exploded view of the supporting member and the actuator in FIG. 1;
FIG. 5 schematically shows a state in which the first cable management bracket and the second cable management bracket of the cable management assembly in an embodiment of the present invention are close to each other and the supporting member lies below both the first cable management bracket and the second cable management bracket;
FIG. 6 schematically shows how the second cable management bracket of the cable management assembly in FIG. 5 is extended relative to the first cable management bracket and thereby rotates the supporting member relative to the supporting base when a second rail of a slide rail assembly is pulled out relative to a first rail of the slide rail assembly;
FIG. 7 schematically shows how the second cable management bracket of the cable management assembly in FIG. 6 is further extended relative to the first cable management bracket and thus further rotates the supporting member relative to the supporting base when the second rail of the slide rail assembly is further pulled out relative to the first rail;
FIG. 8 schematically shows how the first cable management bracket and the second cable management bracket of the cable management assembly in FIG. 7 are brought closer to each other by the second rail of the slide rail assembly when the second rail is retracted with respect to the first rail;
FIG. 9 schematically shows how the first cable management bracket and the second cable management bracket of the cable management assembly in FIG. 8 are brought even closer to each other by the second rail of the slide rail assembly when the second rail is further retracted with respect to the first rail;
FIG. 10 schematically shows how an elastic member of the cable management assembly in an embodiment of the present invention is mounted between the supporting member and the supporting base;
FIG. 11 schematically shows how the first cable management bracket and the second cable management bracket of the cable management assembly in an embodiment of the present invention are directly pivotally connected to each other;
FIG. 12 is a schematic perspective view of the supporting base of the cable management assembly in an embodiment of the present invention;
FIG. 13A schematically shows how the positioning element of the adjusting member of the cable management assembly in FIG. 12 is correspondingly engaged in the first positioning hole of the supporting base;
FIG. 13B schematically shows how the adjusting member of the cable management assembly in FIG. 12 is adjusted, i.e., displaced, with respect to the supporting base;
FIG. 13C schematically shows how the positioning element of the adjusting member of the cable management assembly in FIG. 12 is correspondingly engaged in the second positioning hole of the supporting base;
FIG. 14A is a schematic sectional view showing how the positioning element of the adjusting member of the cable management assembly in FIG. 12 is correspondingly engaged in the first positioning hole of the supporting base;
FIG. 14B is a schematic sectional view showing how a force is applied through the first positioning hole to the positioning element of the adjusting member of the cable management assembly in FIG. 12;
FIG. 14C is a schematic sectional view showing how the adjusting member of the cable management assembly in FIG. 12 is adjusted, i.e., displaced, with respect to the supporting base;
FIG. 14D is a schematic sectional view showing how the positioning element of the adjusting member of the cable management assembly in FIG. 12 is correspondingly engaged in the second positioning hole of the supporting base; and
FIG. 15 schematically shows the supporting base of the cable management assembly in another embodiment of the present invention.

### Detailed Description of the Invention

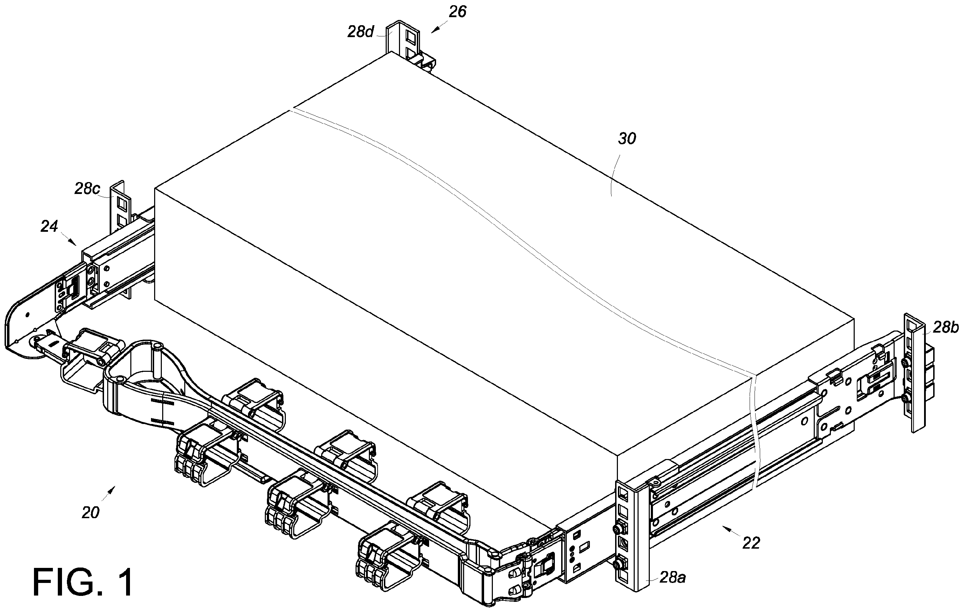

Referring to FIG. 1, the cable management assembly 20 according to an embodiment of the present invention is mounted to a pair of slide rail assemblies, which includes a first slide rail assembly 22 and a second slide rail assembly 24. The slide rail assemblies 22 and 24 are configured to be mounted to a rack 26, and the cable management assembly 20 is configured to be mounted to the rack 26 by way of the slide rail assemblies 22 and 24. Generally, the rack 26 includes a first post 28a, a second post 28b, a third post 28c, and a fourth post 28d. The first slide rail assembly 22 is mounted between the first post 28a and the second post 28b while the second slide rail assembly 24 is mounted between the third post 28c and the fourth post 28d. The first slide rail assembly 22 generally corresponds in position to the second slide rail assembly 24. When in use, an object 30 (e.g., a server, storage device, or other electronic device) can be mounted between the first slide rail assembly 22 and the second slide rail assembly 24 in order for the cable management assembly 20 to keep the cables (not shown) of the object 30 in neat arrangement.

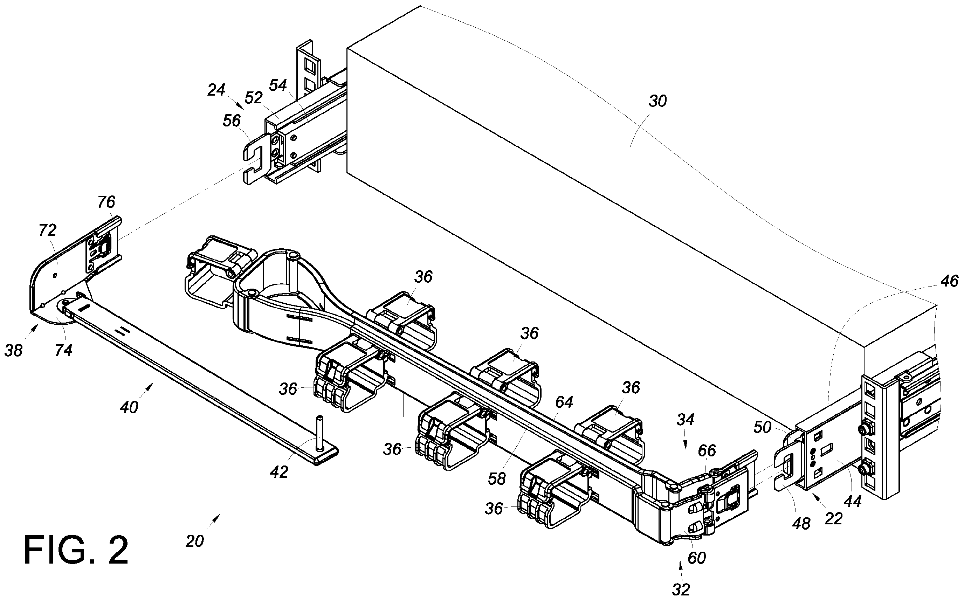

As shown in FIG. 2, the cable management assembly 20 includes a first cable management bracket 32, a second cable management bracket 34 connected to the first cable management bracket 32, a plurality of cable supporting features 36, a supporting base 38, a supporting member 40, and an actuator 42. The first slide rail assembly 22 at least includes a first rail 44 and a second rail 46 which can be longitudinally displaced relative to the first rail 44. The first rail 44 is provided with a connecting base 48, and the second rail 46 is provided with a connecting base 50. The second slide rail assembly 24 includes a first rail 52 and a second rail 54 which can be longitudinally displaced relative to the first rail 52. The first rail 52 is provided with a connecting base 56.

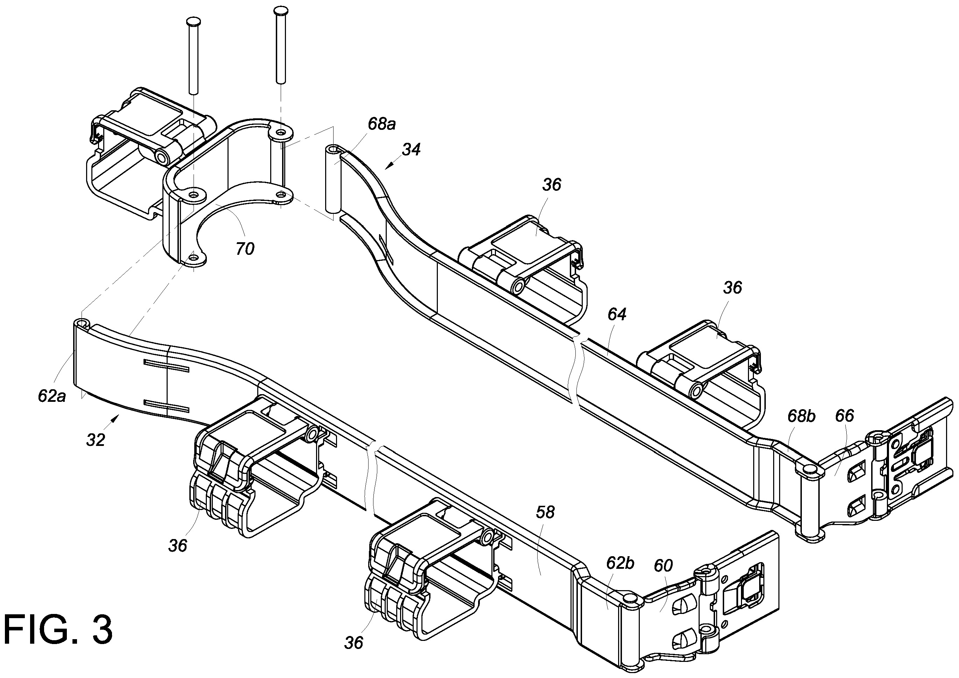

As shown in FIG. 2 and FIG. 3, the first cable management bracket 32 includes a cable management arm 58 and a mounting bracket 60. The cable management arm 58 has a first end 62a and a second end 62b corresponding in position to the first end 62a. The mounting bracket 60 is pivotally connected to the cable management arm 58 at a position adjacent to the second end 62b. When in use, the first cable management bracket 32 is connected to the connecting base 48 of the first rail 44 of the first slide rail assembly 22 via the mounting bracket 60. The second cable management bracket 34, on the other hand, includes a cable management arm 64 and a mounting bracket 66. The cable management arm 64 has a first end 68a and a second end 68b corresponding in position to the first end 68a. In this embodiment, the cable management assembly 20 further includes an intermediate bracket 70 connected between the first end 62a of the cable management arm 58 of the first cable management bracket 32 and the first end 68a of the cable management arm 64 of the second cable management bracket 34. The mounting bracket 66 is pivotally connected to the cable management arm 64 at a position adjacent to the second end 68b. When in use, the second cable management bracket 34 is connected to the connecting base 50 of the second rail 46 of the first slide rail assembly 22 via the mounting bracket 66. The plurality of cable supporting features 36 serve to keep the cables (not shown) of the object 30 in order. The cable supporting features 36 are connected to the first cable management bracket 32 and the second cable management bracket 34.

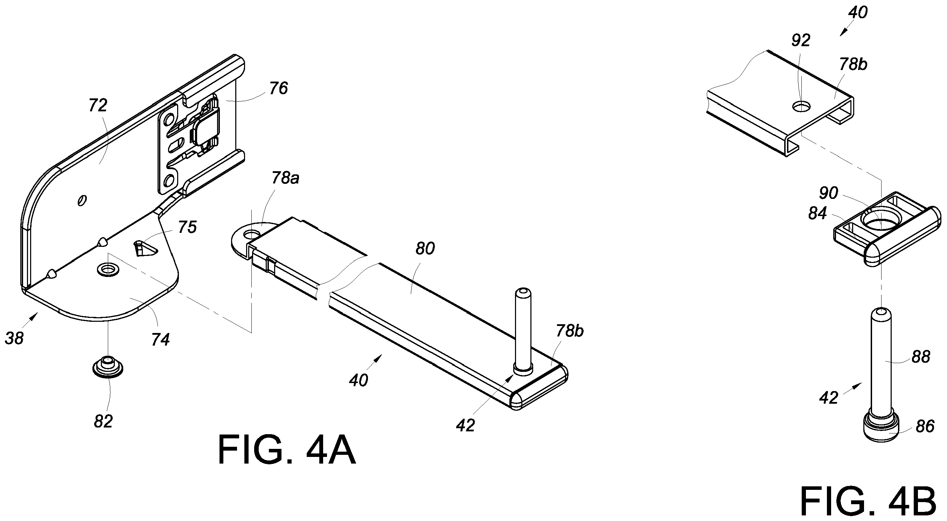

FIG. 4A shows how the supporting base 38 and the supporting member 40 are arranged with respect to each other. As shown in the drawing, the supporting base 38 has a sidewall 72 and a base portion 74 generally perpendicularly connected to the sidewall 72. The sidewall 72 is provided with a mounting bracket 76. When in use, referring to FIG. 2, the supporting base 38 is connected to the connecting base 56 of the first rail 52 of the second slide rail assembly 24 via the mounting bracket 76. The supporting member 40 has a first end 78a, a second end 78b corresponding in position to the first end 78a, and a main body 80 connected between the first end 78a and the second end 78b. The first end 78a of the supporting member 40 is pivotally connected to the base portion 74 of the supporting base 38 via a pivotal connecting element 82 so that the supporting member 40 can rotate freely relative to the base portion 74 of the supporting base 38. In this embodiment, the base portion 74 of the supporting base 38 further has a blocking member 75 for limiting the angle by which the supporting member 40 can be rotated relative to the base portion 74 of the supporting base 38.

Referring to FIG. 4B, the actuator 42 in this embodiment is mounted via an engaging member 84 to the supporting member 40 at a position adjacent to the second end 78b. The actuator 42, which is mounted to the supporting member 40, can be viewed as a part of the supporting member 40. More specifically, the actuator 42 has a head 86 and a body 88 extending from the head 86. The engaging member 84 has a hole 90, and the second end 78b of the supporting member 40 also has a hole 92. The body 88 of the actuator 42 passes the two holes 90 and 92 such that the actuator 42 is mounted to the supporting member 40 at a position adjacent to the second end 78b and stands upright with respect to the main body 80 of the supporting member 40.

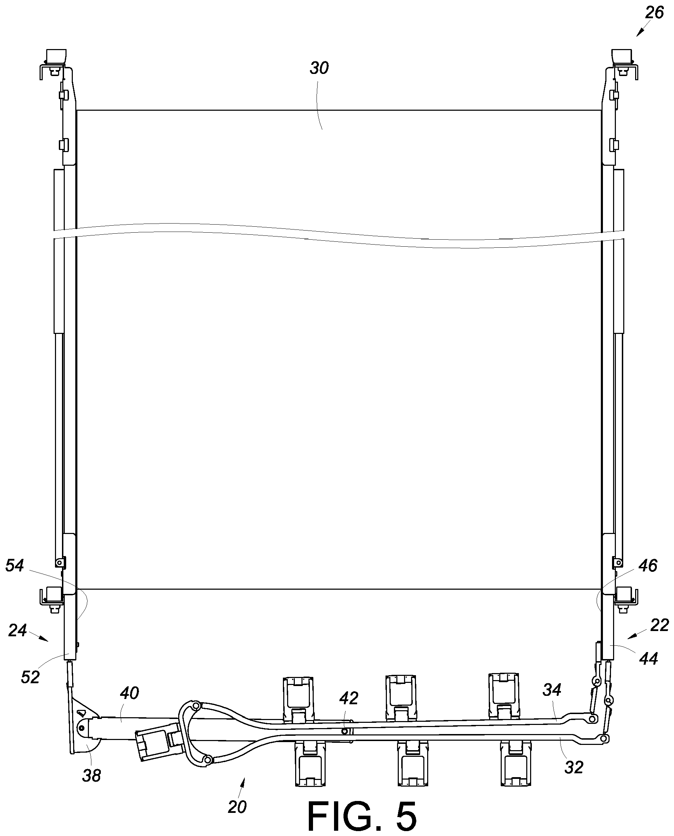

In FIG. 5, the first slide rail assembly 22 and the second slide rail assembly 24 are mounted to the rack 26 and are located within the rack 26. The first cable management bracket 32 of the cable management assembly 20 is mounted to the first rail 44 of the first slide rail assembly 22 while the second cable management bracket 34 is mounted to the second rail 46 of the first slide rail assembly 22. The supporting base 38 is mounted to the first rail 52 of the second slide rail assembly 24. In addition, the object 30 is mounted between the second rail 46 of the first slide rail assembly 22 and the second rail 54 of the second slide rail assembly 24. In the foregoing arrangement, the first cable management bracket 32 and the second cable management bracket 34 are close to each other, and the supporting member 40 lies below both the first cable management bracket 32 and the second cable management bracket 34. When the first cable management bracket 32 and the second cable management bracket 34 are so loaded with cables that they move downward with respect to the supporting member 40, the supporting member 40 can support at least one of the first cable management bracket 32 and the second cable management bracket 34. On the other hand, the actuator 42 corresponds to the first cable management bracket 32 and the second cable management bracket 34. In this embodiment, the actuator 42 corresponds to and is located between the first cable management bracket 32 and the second cable management bracket 34.

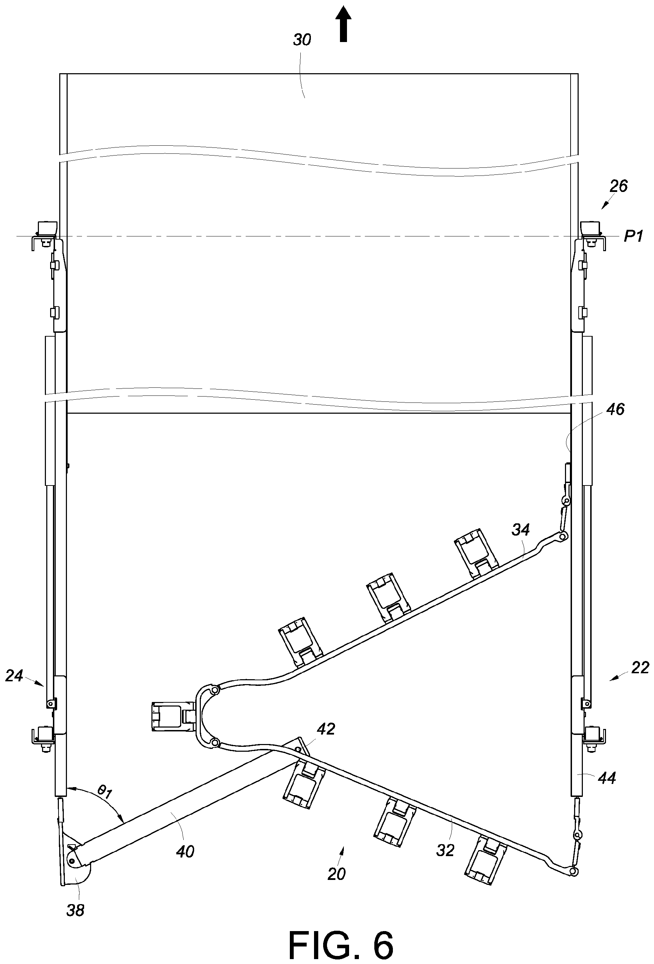

Referring to FIG. 6, in the course in which the object 30 is pulled out from the rack 26 toward a first position P1, the second rail 46 of the first slide assembly 22 is displaced from a retracted position toward an extended position relative to the first rail 44 and therefore drives the first cable management bracket 32 and the second cable management bracket 34 of the cable management assembly 20 to extend. The first cable management bracket 32 in turn drives a portion (e.g., the actuator 42) of the supporting member 40 such that the supporting member 40 is rotated from an initial position by a first angle θ1 with respect to the supporting base 38. Thereby a portion of the first cable management bracket 32 lies on a portion of the supporting member 40 that is adjacent to the actuator 42. Thus, the supporting member 40 in this state effectively supports the first cable management bracket 32 and the second cable management bracket 34 of the cable management assembly 20.

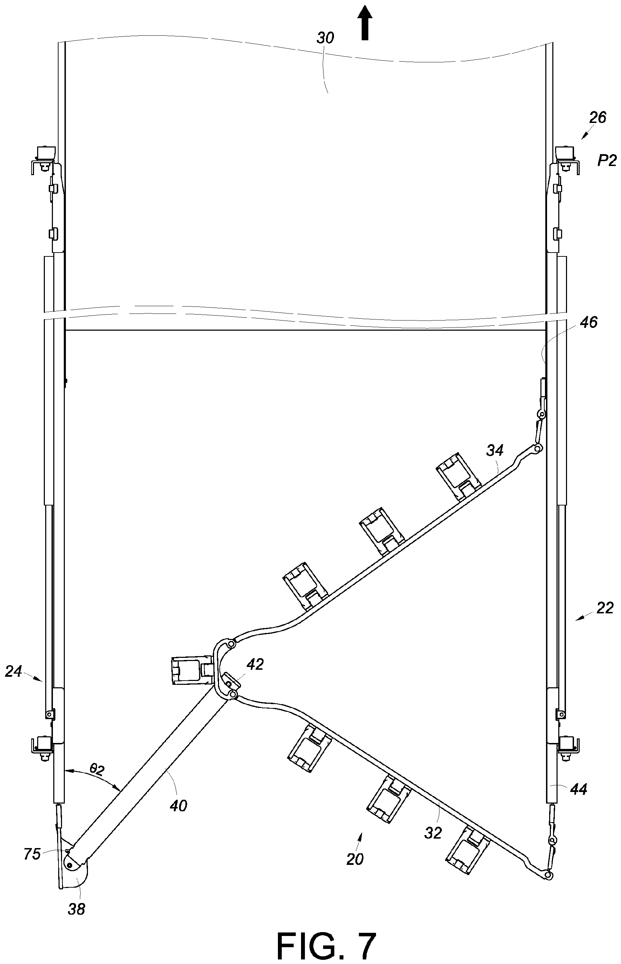

Referring to FIG. 7, in the course in which the object 30 is pulled from the first position P1 toward a second position P2, the first cable management bracket 32 and the second cable management bracket 34 of the cable management assembly 20 are driven to extend further by the second rail 46 of the first slide rail assembly 22 and in turn drive the actuator 42 further such that the supporting member 40 is rotated from the position where it is at the first angle θ1 with respect to the supporting base 38 to another position, where the supporting member 40 is at a second angle θ2 with respect to the supporting base 38 and is pressed against the blocking member 75 of the supporting base 38. In this state, a portion of the first cable management bracket 32 still lies on the supporting member 40 at a position adjacent to the actuator 42, so the supporting member 40 keeps supporting the first cable management bracket 32 and the second cable management bracket 34 of the cable management assembly 20 effectively.

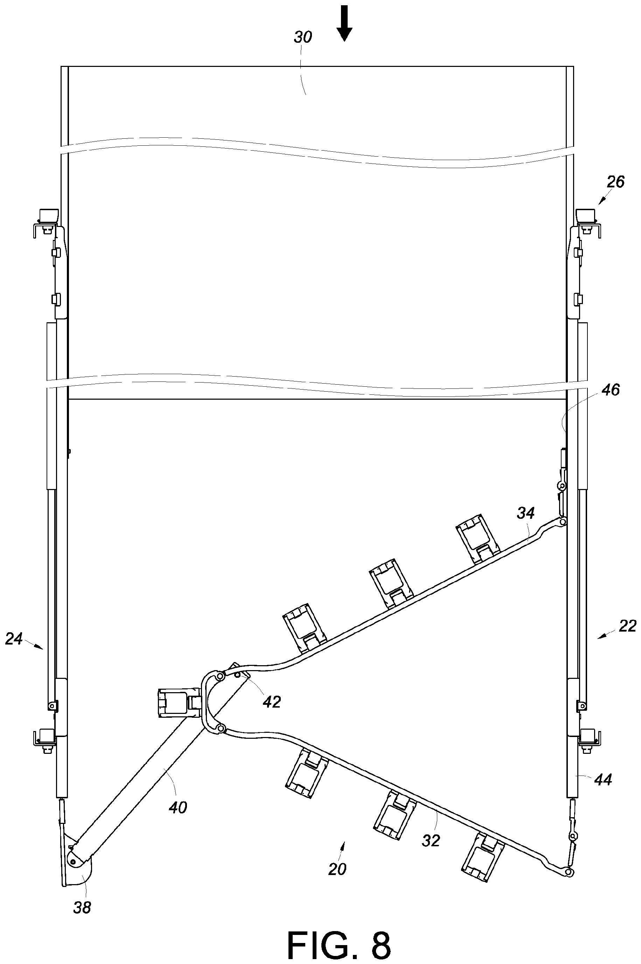

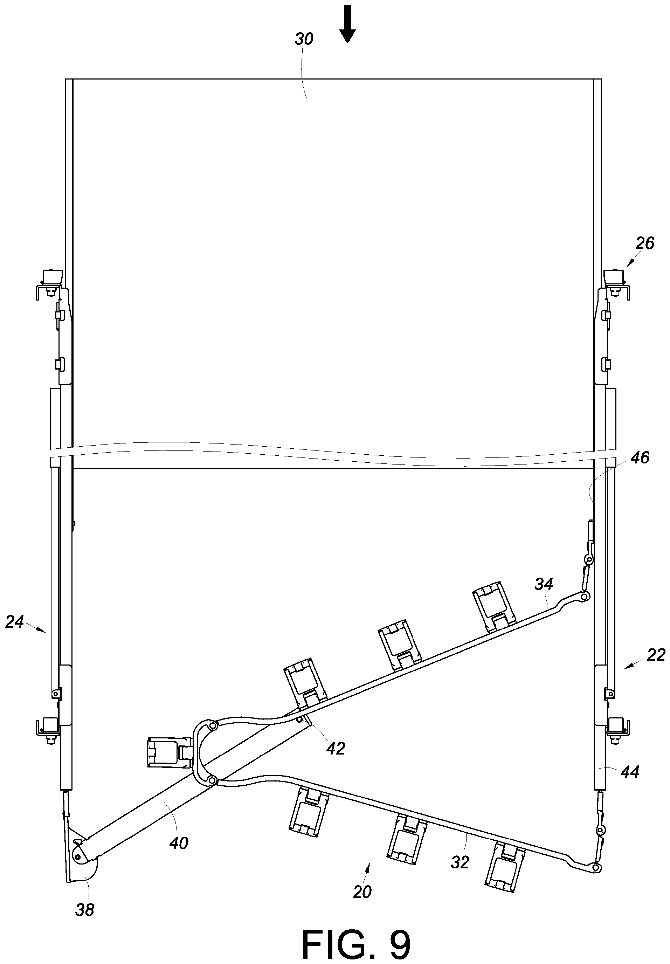

FIG. 8 and FIG. 9 show how the object 30 is pushed back into the rack 26. In the process, the first cable management bracket 32 and the second cable management bracket 34 of the cable management assembly 20 are brought closer to each other by the second rail 46 of the first slide rail assembly 22, and the second cable management bracket 34 drives the actuator 42 in such a way that the supporting member 40 is rotated relative to the supporting base 38 and displaced toward the initial position. Eventually, the cable management assembly 20 can be folded to the state shown in FIG. 5.

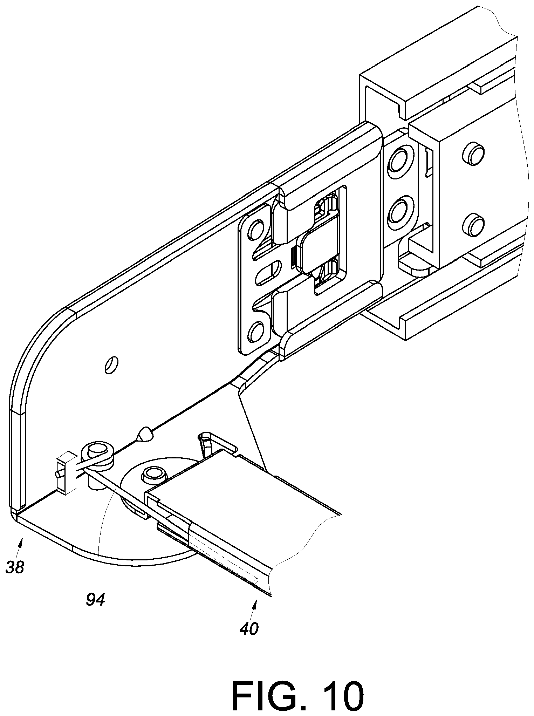

Referring to FIG. 10, the present embodiment further includes an elastic member 94 configured to provide an elastic force when the supporting member 40 is rotated relative to the supporting base 38. The supporting member 40 can respond to the elastic force and therefore rotates readily with respect to the supporting base 38.

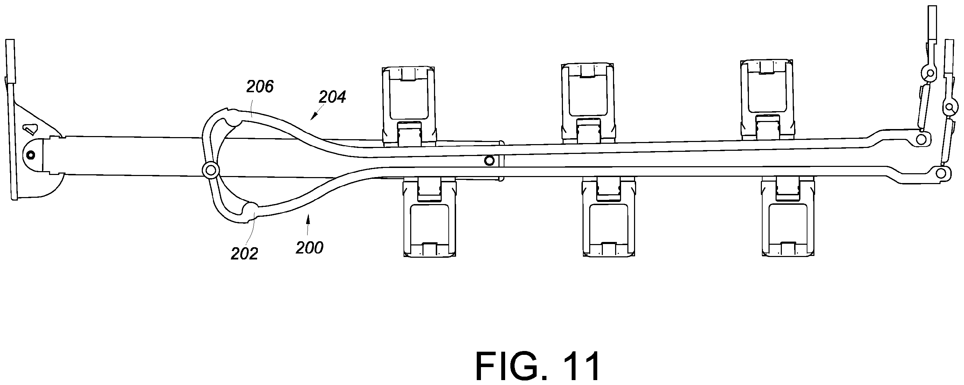

FIG. 11 shows the cable management assembly according to another embodiment of the present invention. In this embodiment, the cable management arm 202 of the first cable management bracket 200 is directly pivotally connected to the cable management arm 206 of the second cable management bracket 204 such that the first cable management bracket 200 and the second cable management bracket 204 are pivotally connected. In other words, this embodiment and the previous embodiment (see FIG. 3) illustrate two feasible relationships between the cable management brackets, namely direct pivotal connection and indirect pivotal connection via the intermediate bracket 70. The present invention imposes no limitations in this regard.

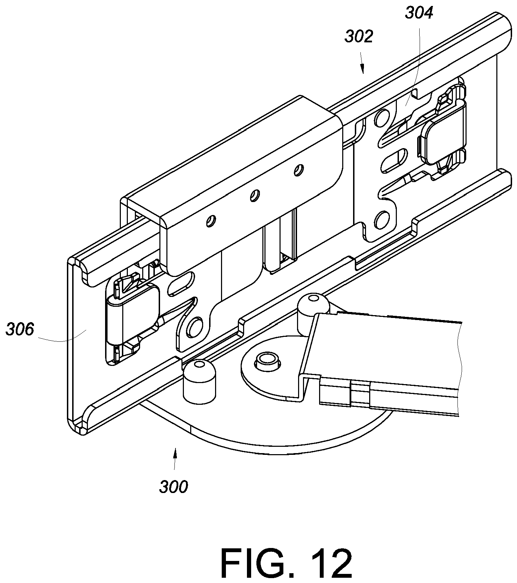

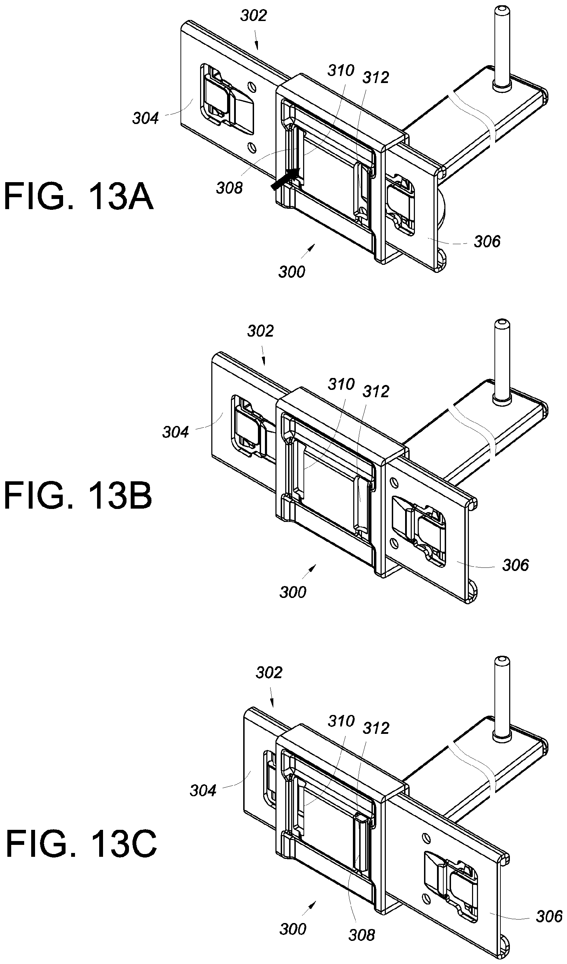

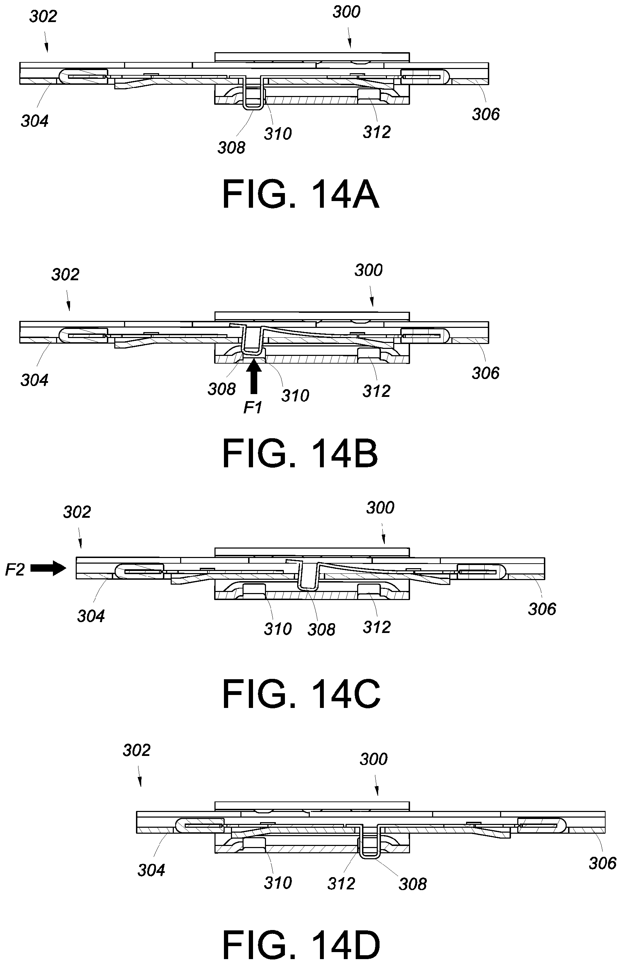

FIG. 12, FIGS. 13A∼ 13C, and FIGS. 14A∼14D show the structure of the supporting base in yet another embodiment of the present invention. In this embodiment, the supporting base 300 includes an adjusting member 302 movably connected to the supporting base 300. The adjusting member 302 includes a first bracket 304, a second bracket 306, and a positioning element 308 elastically mounted to one of the first bracket 304 and the second bracket 306. The supporting base 300 has a first positioning hole 310 and a second positioning hole 312, both of which correspond to the positioning element 308. When the positioning element 308 is engaged, and therefore fixed in position, in the first positioning hole 310 of the supporting base 300, the supporting base 300 can be connected to the connecting base 56 of the first rail 52 of the aforesaid second slide rail assembly 24 via the first bracket 304, as shown in FIG. 2. To operate (i.e., displace) the positioning element 308, referring to FIG. 14B, a force F1 is applied to move the positioning element 308 out of the first positioning hole 310 of the supporting base 300, and a force F2 is applied to displace the adjusting member 302, as shown in FIG. 14C, so that the positioning element 308 is engaged in the second positioning hole 312 of the supporting base 300 and secured in position, as shown in FIG. 14D. The supporting base 300 in this configuration can be connected to the connecting base 48 of the first rail 44 of the aforesaid first slide rail assembly 22 via the second bracket 306. In this embodiment, therefore, the cable management brackets and the supporting base can be selectively and respectively connected to the slide rail assemblies according to actual installation needs.

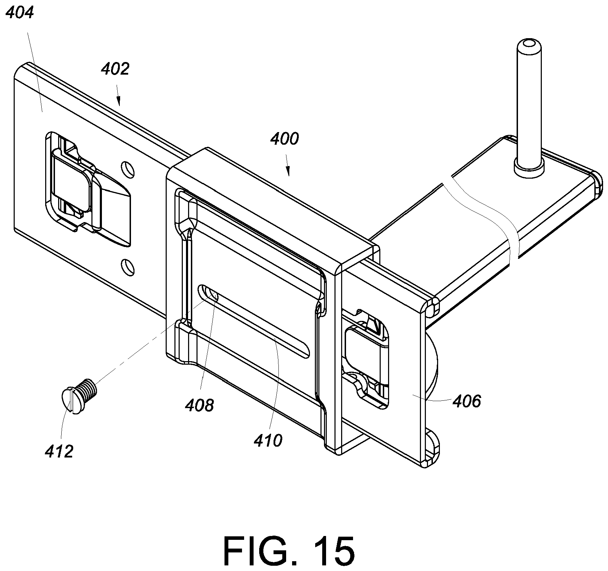

FIG. 15 show the structure of the supporting base in still another embodiment of the present invention. In this embodiment, the supporting base 400 includes an adjusting member 402 movably connected to the supporting base 400. The adjusting member 402 includes a first bracket 404, a second bracket 406, and a threaded hole 408 provided between the first bracket 404 and the second bracket 406. The supporting base 400 has a slot 410, and a portion of the slot 410 corresponds in position to the threaded hole 408. A threaded element 412 is passed through the slot 410, connected with the threaded hole 408, and thereby fixed in position. For adjustment, the threaded element 412 is loosened so that the adjusting member 402 can be moved relative to the supporting base 400. Therefore, the cable management brackets and the supporting base in this embodiment can also be selectively and respectively connected to the slide rail assemblies to meet actual installation needs.

## Claims

1. A cable management assembly (20) for mounting to a pair of slide rail assemblies including a first slide rail assembly (22) and a second slide rail assembly (24) and carrying an object, comprising:
a first cable management bracket (32, 200) adapted to be connected to the first slide rail assembly (22);
a second cable management bracket (34, 204) pivotally connected to the first cable management bracket (32, 200) and adapted to be connected to the first slide rail assembly (22);
a plurality of cable supporting features (36) connected to the first cable management bracket (32, 200) and the second cable management bracket (34, 204);
a supporting base (38, 300, 400) adapted to be connected to the second slide rail assembly (24);
a supporting member (40) configured for supporting at least one of the first cable management bracket (32, 200) and the second cable management bracket (34, 204); and wherein the supporting member (40) has a first end (78a) and a second end (78b) opposite in position to the first end (78a), wherein the first end (78a) of the supporting member (40) is pivotally connected to the supporting base (38, 300, 400) via a pivotal connecting element (82), such that the supporting member (40) is rotatable relative to the supporting base (38, 300, 400);
and the supporting member (40) comprises an upright standing actuator (42) mounted to the supporting member (40) at a position adjacent to the second end (78b) and which actuator (42) is located between the first cable management bracket (32, 200) and the second cable management bracket (34, 204);
wherein upon relative displacement of the first cable management bracket (32, 200) and the second cable management bracket (34, 204), one of the first cable management bracket (32, 200) and the second cable management bracket (34, 204) drives the supporting member (40) to rotate relative to the supporting base (38, 300, 400),
**characterized in,**
**that** the actuator (42) is driven by the first cable management bracket (32, 200) to rotate the supporting member (40), such that the supporting member (40) is rotated from an initial position when the first cable management bracket (32, 200) and the second cable management bracket (34, 204) are displaced from a retracted position toward an extended position, and
**that** the actuator (42) is driven by the second cable management bracket (34, 204) to rotate the supporting member (40), such that the supporting member (40) is displaced toward the initial position when the first and the second cable management bracket (32, 200, 34, 204) are brought closer to each other.

2. The cable management assembly (20) as claimed in claim 1, wherein the cable management assembly (20) is mountable to a rack (26) via the pair of slide rail assemblies (22, 24), the first slide rail assembly (22) including a first rail (44) and a second rail (46) longitudinally displaceable relative to the first rail (44); when the second rail (46) of the first slide rail assembly (22) is displaced relative to the first rail (44) of the first slide rail assembly (22) from the retracted position toward the extended position, the second cable management bracket (34, 204) displaces the first cable management bracket (32, 200) such that the first cable management bracket (32, 200) drives the actuator (42) and thereby rotates the supporting member (40) relative to the supporting base (38, 300, 400) by an angle; and when the second rail (46) of the first slide rail assembly (22) is displaced relative to the first rail (44) of the first slide rail assembly (22) from the extended position toward the retracted position, the second cable management bracket (34, 204) drives the actuator (42) and thereby rotates the supporting member (40) relative to the supporting base (38, 300, 400) toward the initial position of the supporting member (40).

3. The cable management assembly (20) as claimed in claim 2, wherein the first cable management bracket (32, 200) includes a cable management arm (58, 202) having a first end (62a) and a second end (62b), the second cable management bracket (34, 204) includes a cable management arm (64, 206) having a first end (68a) and a second end (68b), and the cable management assembly (20) further comprises an intermediate bracket (70) pivotally connected between the first end (62a) of the cable management arm (58, 202) of the first cable management bracket (32, 200) and the first end (68a) of the cable management arm (64, 206) of the second cable management bracket (34, 204).

4. The cable management assembly (20) as claimed in claim 3, further comprising a first mounting bracket (60) pivotally connected to the second end (62b) of the cable management arm (58, 202) of the first cable management bracket (32, 200), the first cable management bracket (32, 200) being connectable to the first rail (44) of the first slide rail assembly (22) via the first mounting bracket (60); and a second mounting bracket (66) pivotally connected to the second end (68b) of the cable management arm (64, 206) of the second cable management bracket (34, 204), the second cable management bracket (34, 204) being connectable to the second rail (46) of the first slide rail assembly (22) via the second mounting bracket (66).

5. The cable management assembly (20) as claimed in claim 2, wherein the supporting base (38, 300, 400) has a sidewall (72) and a base portion (74) generally perpendicularly connected to the sidewall (72), and the sidewall (72) is provided with a third mounting bracket (76), the supporting base (38, 300, 400) being connectable to the second slide rail assembly (24) via the third mounting bracket (76).

6. The cable management assembly (20) as claimed in claim 5, wherein the base portion (74) of the supporting base (38, 300, 400) has a blocking member (75) for limiting an angle by which the supporting member (40) is allowed to be rotated relative to the base portion (74) of the supporting base (38, 300, 400).

7. The cable management assembly (20) as claimed in claim 1 or 2, wherein the supporting member (40) has a main body (80) connected between the first end (78a) and the second end (78b) of the supporting member (40); and the actuator (42) is mounted to the second end (78b) of the supporting member (40) via an engaging member (84) and is thereby rendered upright with respect to the main body (80) of the supporting member (40).

8. The cable management assembly (20) as claimed in claim 1 or 2, further comprising an elastic member (94) for providing an elastic force when the supporting member (40) is rotated relative to the supporting base (38, 300, 400), wherein the supporting member (40) is able to respond to the elastic force and therefore be rotated relative to the supporting base (38, 300, 400) with ease.

9. The cable management assembly (20) as claimed in claim 1 or 2, wherein the supporting base (300) comprises an adjusting member (302) movably connected to the supporting base (300); the adjusting member (302) includes a first bracket (304), a second bracket (306), and a positioning element (308) elastically mounted to one of the first bracket (304) and the second bracket (306); and the supporting base (300) has a first positioning hole (310) and a second positioning hole (312), the first positioning hole (310) and the second positioning hole (312) both corresponding to the positioning element (308).

10. The cable management assembly (20) as claimed in claim 1 or 2, wherein the supporting base (400) comprises an adjusting member (402) movably connected to the supporting base (400); the adjusting member (402) includes a first bracket (404), a second bracket (406), and a threaded hole (408) provided between the first bracket (404) and the second bracket (406); and the supporting base (400) has a slot (410) having a portion corresponding in position to the threaded hole (408) so that a threaded element (412) can pass through the slot (410), connect with the threaded hole (408), and thus be fixed in position.

## Patentansprüche

1. Ein Kabelführungspaket (20) für die Montage eines Paars Laufschienenmontagen, die aus einer ersten Laufschienenmontage (22) und einer zweite Laufschienenmontage (24) bestehen und einen Gegenstand tragen, umfassend:
eine erste Halterung mit Kabelführung (32, 200), die zum Befestigen an die erste Laufschienenmontage (22) konfiguriert ist;
eine zweite Halterung mit Kabelführung (34, 204), die drehgelenkig an der ersten Halterung mit Kabelführung (32, 200) befestigt und zum Befestigen an die erste Laufschienenmontage (22) konfiguriert ist;
mehrere Kabelhaltevorrichtungen (36), die an die erste Halterung mit Kabelführung (32, 200) und an die zweite Halterung mit Kabelführung (34, 204) befestigt sind;
eine tragende Basis (38, 300, 400), die zum Befestigen an die zweite Laufschienenmontage (24) konfiguriert ist;
ein tragendes Glied (40) zum Tragen von mindestens eine der ersten Halterungen mit Kabelführung (32, 200) und der zweiten Halterungen mit Kabelführung (34, 204) konfiguriert ist; wobei das tragende Glied (40) einen ersten Endabschnitt (78a) und einen zweiten Endabschnitt (78b) in der Position gegenüber dem ersten Endabschnitt (78a) aufweist; der erste Endabschnitt (78a) des tragenden Glieds (40) mit einem drehgelenkigen Verbindungselement (82) drehgelenkig an der tragenden (38, 300, 400) befestigt ist, so dass das tragende Glied (40) an der tragenden Basis (38, 300, 400) rotierbar ist;
und das tragende Glied (40) einen aufrecht stehenden Aktuator (42) umfasst, der in einer Position neben dem zweiten Endabschnitt (78b) am tragenden Glied (40) montiert ist und wobei der Aktuator (42) zwischen der ersten Halterung mit Kabelführung (32, 200) und der zweiten Halterung mit Kabelführung (34, 204) angeordnet ist;
wobei bei der relativen Verschiebung der ersten Halterung mit Kabelführung (32, 200) und der zweiten Halterung mit Kabelführung (34, 204) mit eine der ersten Halterungen mit Kabelführung (32, 200) und der zweiten Halterungen mit Kabelführung (34, 204) das tragende Glied (40) zum Rotieren an der tragenden Basis (38, 300, 400) angetrieben wird;
**dadurch gekennzeichnet, dass**
der Aktuator (42) mit der ersten Halterung mit Kabelführung (32, 200) zum Rotieren des tragenden Glieds (40) angetrieben wird, so dass das tragende Glied (40) aus einer Ausgangsposition rotiert wird, wenn die erste Halterung mit Kabelführung (32, 200) und die zweite Halterung mit Kabelführung (34, 204) aus einer eingezogenen Position in eine ausgefahrene Position verschoben werden, und
der Aktuator (42) mit der zweiten Halterung mit Kabelführung (34, 204) zum Rotieren des tragenden Glieds (40) angetrieben wird, so dass das tragende Glied (40) in eine Ausgangsposition verschoben wird, wenn die erste und zweite Halterung mit Kabelführung (32, 200, 34, 204) näher aneinander gebracht werden.

2. Das Kabelführungspaket (20) nach Anspruch 1, wobei das Kabelführungspaket (20) mit dem Paar Laufschienenmontagen (22, 24) an eine Zahnstange (26) montiert werden kann; die erste Laufschienenmontage (22) aus einer ersten Schiene (44) und einer zweiten Schiene (46) besteht, wobei letztere der Länge nach an der ersten Schiene (44) verschiebbar ist; beim Verschieben der zweiten Schiene (46) der ersten Laufschienenmontage (22) an der ersten Schiene (44) der ersten Laufschienenmontage (22) aus der eingezogenen Position in die ausgefahrene Position die erste Halterung mit Kabelführung (32, 200) mit der zweiten Halterung mit Kabelführung (34, 204) so verschoben wird, dass mit der ersten Halterung mit Kabelführung (32, 200) der Aktuator (42) angetrieben und dadurch das tragende Glied (40) an der tragenden Basis (38, 300, 400) um einen Winkel rotiert wird; beim Verschieben der zweiten Schiene (46) der ersten Laufschienenmontage (22) an der ersten Schiene (44) der ersten Laufschienenmontage (22) aus der ausgefahrenen Position in die eingezogene Position mit der zweiten Halterung mit Kabelführung (34, 204) der Aktuator (42) angetrieben und dadurch das tragende Glied (40) an der tragenden Basis (38, 300, 400) in die Ausgangsposition des tragenden Glieds (40) rotiert wird.

3. Das Kabelführungspaket (20) nach Anspruch 2, wobei die erste Halterung mit Kabelführung (32, 200) aus einem Kabelführungsarm (58, 202) mit einem ersten Endabschnitt (62a) und einem zweiten Endabschnitt (62b) besteht; die zweite Halterung mit Kabelführung (34, 204) aus einem Kabelführungsarm (64, 206) mit einem ersten Endabschnitt (68a) und einem zweiten Endabschnitt (68b) besteht, während das Kabelführungspaket (20) weiter eine Zwischenhalterung (70) umfasst, die drehgelenkig zwischen dem ersten Endabschnitt (62a) des Kabelführungsarms (58, 202) der ersten Halterung mit Kabelführung (32, 200) und dem ersten Endabschnitt (68a) des Kabelführungsarms (64, 206) der zweiten Halterung mit Kabelführung (34, 204) befestigt ist.

4. Das Kabelführungspaket (20) nach Anspruch 3, weiter umfassend eine erste Montagehalterung (60), die drehgelenkig am zweiten Endabschnitt (62b) des Kabelführungsarms (58, 202) der ersten Halterung mit Kabelführung (32, 200) befestigt ist; die erste Halterung mit Kabelführung (32, 200) mit der ersten Montagehalterung (60) an die erste Schiene (44) der ersten Laufschienenmontage (22) befestigt werden kann; eine zweite Montagehalterung (66) drehgelenkig am zweiten Endabschnitt (68b) des Kabelführungsarms (64, 206) der zweiten Halterung mit Kabelführung (34, 204) befestigt ist; die zweite Halterung mit Kabelführung (34, 204) mit der zweiten Montagehalterung (66) an die zweite Schiene (46) der ersten Laufschienenmontage (22) befestigt werden kann.

5. Das Kabelführungspaket (20) nach Anspruch 2, wobei die tragende Basis (38, 300, 400) eine Seitenwand (72) und einen Basisteil (74) aufweist, wobei letzterer generell senkrecht an der Seitenwand (72) befestigt ist; die Seitenwand (72) eine dritte Montagehalterung (76) aufweist; die tragende Basis (38, 300, 400) mit der dritten Montagehalterung (76) an die zweite Laufschienenmontage (24) befestigt werden kann.

6. Das Kabelführungspaket (20) nach Anspruch 5, wobei der Basisteil (74) der tragenden Basis (38, 300, 400) ein Sperrglied (75) zum Begrenzen eines Winkels aufweist, durch den das tragende Glied (40) am Basisteil (74) der tragenden Basis (38, 300, 400) rotiert werden kann.

7. Das Kabelführungspaket (20) nach Anspruch 1 oder 2, wobei das tragende Glied (40) einen Hauptkörper (80) aufweist, der zwischen dem ersten Endabschnitt (78a) und dem zweiten Endabschnitt (78b) des tragenden Glieds (40) befestigt ist; der Aktuator (42) mit einem Einrastglied (84) am zweiten Endabschnitt (78b) des tragenden Glieds (40) montiert ist und daher hinsichtlich zum Hauptkörper (80) des tragenden Glieds (40) in eine aufrechte Position gebracht wird.

8. Das Kabelführungspaket (20) nach Anspruch 1 oder 2, weiter umfassend eine Feder (94) zum Erzeugen einer Federkraft, wenn das tragende Glied (40) an der tragenden Basis (38, 300, 400) rotiert wird; wobei das tragende Glied (40) auf die Federkraft reagieren und daher leicht an der tragenden Basis (38, 300, 400) rotiert werden kann.

9. Das Kabelführungspaket (20) nach Anspruch 1 oder 2, wobei die tragende Basis (300) ein Stellglied (302) umfasst, das beweglich an der tragenden Basis (300) befestigt ist; das Stellglied (302) aus einer ersten Halterung (304), einer zweiten Halterung (306) und einem Positionierelement (308) besteht, wobei letzteres elastisch an einem der ersten Halterungen (304) und der zweiten Halterungen (306) montiert ist; die tragende Basis (300) ein erstes Positionierloch (310) und ein zweites Positionierloch (312) aufweist; das erste Positionierloch (310) und das zweite Positionierloch (312) mit dem Positionierelement (308) übereinstimmen.

10. Das Kabelführungspaket (20) nach Anspruch 1 oder 2, wobei die tragende Basis (400) ein Stellglied (402) umfasst, das beweglich an der tragenden Basis (400) befestigt ist; das Stellglied (402) aus einer ersten Halterung (404) und einer zweiten Halterung (406) besteht; zwischen der ersten Halterung (404) und der zweiten Halterung (406) ein Gewindeloch (408) gebildet ist; die tragende Basis (400) eine Nut (410) aufweist, deren ein Teil mit dessen Position mit dem Gewindeloch (408) übereinstimmt, so dass ein Gewinde (412) die Nut (410) durchqueren, im Gewindeloch (408) befestigt und so in seiner Position befestigt werden kann.

## Revendications

1. Ensemble de gestion de câbles (20) pour montage sur une paire d'ensembles de rails coulissants comprenant un premier ensemble de rails coulissants (22) et un second ensemble de rails coulissants (24) et portant un objet, **caractérisé par le fait qu'**il comprend :
un premier support de gestion de câbles (32, 200) adapté pour être raccordé au premier ensemble de rails coulissants (22) ;
un second support de gestion de câbles (34, 204) raccordé de manière pivotante au premier support de gestion de câbles (32, 200) et adapté pour être raccordé au premier ensemble de rails coulissants (22) ;
une pluralité de fonctionnalités de support de câbles (36) raccordées au premier support de gestion de câbles (32, 200) et au second support de gestion de câbles (34, 204) ;
une base de support (38, 300, 400) adaptée pour être raccordée au second ensemble de rails coulissants (24) ;
un élément de support (40) configuré pour supporter au moins l'un des premier support de gestion de câbles (32, 200) et second support de gestion de câbles (34, 204) ; et l'élément de support (40) comporte une première extrémité (78a) et une seconde extrémité (78b) en face de la première extrémité (78a), la première extrémité (78a) de l'élément de support (40) est raccordée de manière pivotante à la base de support (38, 300, 400) via un élément de raccordement pivotant (82), de telle sorte que l'élément de support (40) est rotatif par rapport à la base de support (38, 300, 400) ;
et l'élément de support (40) comprend un actionneur en position verticale (42) monté sur l'élément de support (40) à une position adjacente à la seconde extrémité (78b) et ledit actionneur (42) est situé entre le premier support de gestion de câbles (32, 200) et le second support de gestion de câbles (34, 204) ; lors du déplacement l'un par rapport à l'autre du premier support de gestion de câbles (32, 200) et du second support de gestion de câbles (34, 204), l'un des premier support de gestion de câbles (32, 200) et second support de gestion de câbles (34, 204) entraîne la rotation de l'élément de support (40) par rapport à la base de support (38, 300, 400),
**caractérisé en ce que**,
l'actionneur (42) est entraîné par le premier support de gestion de câbles (32, 200) pour faire pivoter l'élément de support (40), de telle sorte que l'élément de support (40) est pivoté depuis une position initiale lorsque le premier support de gestion de câbles (32, 200) et le second support de gestion de câbles (34, 204) sont déplacés depuis une position rétractée vers une position étendue, et
l'actionneur (42) est entraîné par le second support de gestion de câbles (34, 204) pour faire pivoter l'élément de support (40), de telle sorte que l'élément de support (40) est déplacé vers la position initiale lorsque le premier et le second support de gestion de câbles (32, 200, 34, 204) sont rapprochés l'un de l'autre.

2. Ensemble de gestion de câbles (20) selon la revendication 1, **caractérisé par le fait que** l'ensemble de gestion de câbles (20) est montable sur un bâti (26) via la paire d'ensembles de rails coulissants (22, 24), le premier ensemble de rails coulissants (22) comprenant un premier rail (44) et un second rail (46) déplaçable longitudinalement par rapport au premier rail (44) ; lorsque le second rail (46) du premier ensemble de rails coulissants (22) est déplacé par rapport au premier rail (44) du premier ensemble de rails coulissants (22) depuis la position rétractée vers la position étendue, le second support de gestion de câbles (34, 204) déplace le premier support de gestion de câbles (32, 200) de telle sorte que le premier support de gestion de câbles (32, 200) entraîne l'actionneur (42) et fait ainsi pivoter d'un angle l'élément de support (40) par rapport à la base de support (38, 300, 400) ; et lorsque le second rail (46) du premier ensemble de rails coulissants (22) est déplacé par rapport au premier rail (44) du premier ensemble de rails coulissants (22) depuis la position étendue vers la position rétractée, le second support de gestion de câbles (34, 204) entraîne l'actionneur (42) et fait ainsi pivoter l'élément de support (40) par rapport à la base de support (38, 300, 400) vers la position initiale de l'élément de support (40).

3. Ensemble de gestion de câbles (20) selon la revendication 2, **caractérisé par le fait que** le premier support de gestion de câbles (32, 200) comprend un bras de gestion des câbles (58, 202) comportant une première extrémité (62a) et une seconde extrémité (62b), le second support de gestion de câbles (34, 204) comprend un bras de gestion des câbles (64, 206) comportant une première extrémité (68a) et une seconde extrémité (68b), et l'ensemble de gestion de câbles (20) comprend en outre un support intermédiaire (70) raccordé de manière pivotante entre la première extrémité (62a) du bras de gestion des câbles (58, 202) du premier support de gestion de câbles (32, 200) et la première extrémité (68a) du bras de gestion des câbles (64, 206) du second support de gestion de câbles (34, 204).

4. Ensemble de gestion de câbles (20) selon la revendication 3, **caractérisé par le fait qu'**il comprend en outre un premier support de montage (60) raccordé de manière pivotante à la seconde extrémité (62b) du bras de gestion des câbles (58, 202) du premier support de gestion de câbles (32, 200), le premier support de gestion de câbles (32, 200) pouvant être raccordé au premier rail (44) du premier ensemble de rails coulissants (22) via le premier support de montage (60) ; et un deuxième support de montage (66) raccordé de manière pivotante à la seconde extrémité (68b) du bras de gestion des câbles (64, 206) du second support de gestion de câbles (34, 204), le second support de gestion de câbles (34, 204) pouvant être raccordé au second rail (46) du premier ensemble de rails coulissants (22) via le deuxième support de montage (66).

5. Ensemble de gestion de câbles (20) selon la revendication 2, **caractérisé par le fait que** la base de support (38, 300, 400) comporte une paroi latérale (72) et une partie de base (74) généralement perpendiculairement raccordée à la paroi latérale (72), et la paroi latérale (72) est équipée d'un troisième support de montage (76), la base de support (38, 300, 400) pouvant être raccordée au second ensemble de rails coulissants (24) via le troisième support de montage (76).

6. Ensemble de gestion de câbles (20) selon la revendication 5, **caractérisé par le fait que** la partie de base (74) de la base de support (38, 300, 400) comporte un élément de blocage (75) pour limiter un angle grâce auquel l'élément de support (40) est autorisé à pivoter par rapport à la partie de base (74) de la base de support (38, 300, 400).

7. Ensemble de gestion de câbles (20) selon la revendication 1 ou 2, **caractérisé par le fait que** l'élément de support (40) comporte un corps principal (80) raccordé entre la première extrémité (78a) et la seconde extrémité (78b) de l'élément de support (40) ; et l'actionneur (42) est monté sur la seconde extrémité (78b) de l'élément de support (40) via un élément d'engagement (84) et est ainsi mis en position verticale par rapport au corps principal (80) de l'élément de support (40).

8. Ensemble de gestion de câbles (20) selon la revendication 1 ou 2, **caractérisé par le fait qu'**il comprend en outre un élément élastique (94) pour fournir une force élastique lorsque l'élément de support (40) est pivoté par rapport à la base de support (38, 300, 400), l'élément de support (40) est capable de répondre à la force élastique et donc d'être facilement pivoté par rapport à la base de support (38, 300, 400).

9. Ensemble de gestion de câbles (20) selon la revendication 1 ou 2, **caractérisé par le fait que** la base de support (300) comprend un élément de réglage (302) raccordé de manière mobile à la base de support (300) ; l'élément de réglage (302) comprend un premier support (304), un second support (306), et un élément de positionnement (308) monté élastiquement sur l'un des premier support (304) et second support (306) ; et la base de support (300) comporte un premier trou de positionnement (310) et un second trou de positionnement (312), le premier trou de positionnement (310) et le second trou de positionnement (312) correspondant tous deux à l'élément de positionnement (308).

10. Ensemble de gestion de câbles (20) selon la revendication 1 ou 2, **caractérisé par le fait que** la base de support (400) comprend un élément de réglage (402) raccordé de manière mobile à la base de support (400) ; l'élément de réglage (402) comprend un premier support (404), un second support (406), et un trou fileté (408) prévu entre le premier support (404) et le second support (406) ; et la base de support (400) comporte une fente (410) comportant une partie correspondant en position au trou fileté (408) de sorte qu'un élément fileté (412) peut passer à travers la fente (410), se raccorder au trou fileté (408), et être ainsi fixé en place.
